# EUROPÄISCHE PATENTANMELDUNG

(11) **EP 4 574 800 A1**
(43) Veröffentlichungstag der Anmeldung: **25.06.2025**
(21) Anmeldenummer: 24216459.8
(22) Anmeldetag: 29.11.2024
(51) Int. Cl.: C04B 37/02, C04B 41/00, C04B 41/52, C04B 41/88

(54) **METALLISIERUNG, UND TRÄGER MIT METALLISIERUNG**

(30) Priorität: 18.12.2023 EP 23217418
(71) Anmelder: Kistler Holding AG, 8408 Winterthur (CH)
(72) Erfinder: Mastrogiacomo, Giovanni, 8005 Zürich (CH); Märki, Hans Beat, 8483 Kollbrunn (CH); Pfister, Urs, 8400 Winterthur (CH)

(57) **Zusammenfassung**

System (36) aufweisend einen Träger (3) und mindestens eine Metallisierung (6); wobei die Metallisierung (6) zumindest eine erste Schicht (1) und eine zweite Schicht (2) aufweist; wobei der Träger (3) eine Trägeroberfläche (7) aufweist; wobei die erste Schicht (1) zwischen Trägeroberfläche und der zweiten Schicht (2) angeordnet ist; wobei die zweite Schicht (2) zu mindestens 90 Gew.% aus einem Edelmetall ausgeführt ist; wobei die erste Schicht (1) aus Übergangsmetallen und/oder Metallen und/oder Halbmetallen ausgeführt ist; wobei die erste Schicht (1) ultraschalldämpfend ist.

## Beschreibung

### Technisches Gebiet

Die Erfindung betrifft eine Metallisierung aufweisend eine erste Schicht und eine zweite Schicht, und einen Träger, beispielsweise eine Oxidkeramik, mit Metallisierung mit verbesserter Beständigkeit.

### Stand der Technik

Oxidkeramiken kommen als Träger, auch als Substrat bezeichnet, in einer Vielzahl von Anwendungen zum Einsatz, beispielsweise als Isolator, Substrat in Leiterplatten oder als Messelement.

Träger werden in technischen Anwendungen oft mit einer Metallisierung versehen. Diese ist oft zur Leitung von elektrischen Ladungen vorgesehen. So kann so eine Metallisierung als Leiterbahn, als Elektrode oder als Schutz vor statischer Aufladung von ansonsten elektrisch isolierenden Oberflächen vorgesehen sein. Die Metallisierung bedeckt dabei zumindest einen Teilbereich einer Oxidkeramikoberfläche.

Für die Metallisierung von Oxidkeramiken wie Quarz, Galiumphosphat oder Langasit werden in der Regel Schichtaufbauten aus Refraktärmetallen und Edelmetallen verwendet. Die Refraktärmetallschicht dient als Haftvermittlerschicht, da sie aufgrund ihrer hohen Sauerstoffaffinität eine gute Haftung zu den Oxidkeramiken ermöglicht. Die Edelmetallschicht hingegen dient der guten elektrischen Leitfähigkeit und/oder der Bondbarkeit der Schicht.

Unter Refraktärmetallen werden Elemente der 4. Nebengruppe (Titan, Zirconium und Hafnium), der 5. Nebengruppe (Vanadium, Niob und Tantal), oder der 6. Nebengruppe (Chrom, Molybdän und Wolfram) verstanden. Als Edelmetalle werden im Sinne dieser Anmeldung Gold, Platin, Iridium, Palladium, Osmium, Ruthenium, Rhodium und Silber verstanden.

Eine Bondbarkeit besteht, wenn ein Leiter, beispielsweise ein Bonddraht aus Gold oder Aluminium, mittels gängiger Bondtechnologien wie dem Drahtbonden, auch unter dem Begriff Ultraschall-Bonden oder Thermosonic-Bonden bekannt, eine stoffschlüssige Verbindung, auch Kontaktierung genannt, zwischen einer Schicht und dem Leiter ausgeführt werden kann.

Bekannterweise weisen Werkstoffe mit hohem Elastizitätsmodul, wie beispielsweise die Refraktärmetalle, eine nur geringe Dämpfungseigenschaft gegenüber mechanischen Schwingungen auf. Dies ist nachteilig, da der beim Drahtbonden eingesetzte Ultraschall gut auf den Träger übertragen wird. Die daraus resultierende mechanische Beanspruchung durch die mechanischen Schwingungen des Ultraschalls führt oftmals zu Abplatzungen und/oder Rissen im Träger, insbesondere in einem oxidkeramischen Träger, die wiederum die Haftfestigkeit der stoffschlüssigen Verbindung, hier auch Bondung oder Bond genannt, herabsetzen. Risse und/oder Abplatzungen werden allgemein als Schäden bezeichnet, welche durch die schwingungsinduzierten mechanischen Spannungen, auch mechanische Belastung genannte, verursacht sind.

Unter Ultraschall wird allgemein Schall bzw. Schallwellen mit einer Frequenz zwischen 20 kHz und 1 GHz verstanden. Schallwellen sind mechanische Schwingungen.

Insbesondere bei Oxidkeramiken als Träger, welche piezoelektrische Eigenschaften aufweisen und als Messelement in mechanisch beanspruchten Aufnehmern genutzt werden, sind Abplatzungen und/oder Risse im Träger in der Nähe oder an der Position einer Kontaktierung, nicht akzeptabel. Denn die mechanische Beanspruchung, beispielsweise eine Beschleunigung des Aufnehmers, kann zu einem Schaden in der Kontaktierung führen.

Piezoelektrische Messelemente, wie aus EP2013597A1 und EP2029988A2 bekannt, weisen oftmals eine Metallisierung in Form einer elektrisch leitenden Schicht auf. Zum mechanischen Schutz des oftmals spröden piezoelektrischen Materials, welches oftmals auch als Einkristall ausgeführt ist, wird zum Teil Platin als elektrisch Leitende Schicht verwendet. Platin weist als Edelmetall auch eine gute chemische Beständigkeit gegen Oxydation auf. Nachteilig ist hierbei, dass bei der Kontaktierung der Metallisierung mittels Drahtbonden der Piezoelektrische Kristall unterhalb der Metallisierung durch die übertragenen mechanischen Schwingungen des Ultraschalls beschädigt werden kann. Dies ist durch die Metallisierung zunächst nicht direkt sichtbar, da die Metallisierung normalerweise keine Beschädigung aufweist, führt aber zu einer unzureichenden Haltbarkeit bzw. Haftfestigkeit der Kontaktierung der Metallisierung mit einem Leiter, da die Verbindung der Metallisierung zum piezoelektrischen Messelement geschädigt ist.

Aufgabe der Erfindung ist es eine Metallisierung für einen Träger bereitzustellen, der die oben genannten Nachteile vermindert. Eine weitere Aufgabe der Erfindung ist es, eine mechanische Beanspruchung des Trägers durch Vibrationen, wie z.B. Ultraschall, beim Drahtbonden zu reduzieren. Eine weitere Aufgabe der Erfindung ist es, ein System aus Metallisierung und Träger bereitzustellen, der gut mittels Drahtbonden kontaktierbar ist.

### Darstellung der Erfindung

Die Aufgabe wird durch die Merkmale der unabhängigen Ansprüche gelöst.

Die Erfindung betrifft System aufweisend einen Träger und mindestens eine Metallisierung. Die Metallisierung weist zumindest eine erste Schicht und eine zweite Schicht auf. Der Träger weist eine Trägeroberfläche auf. Die erste Schicht ist zwischen der Trägeroberfläche und der zweiten Schicht angeordnet.

Eine Schicht, auch Beschichtung genannt, ist auf einem Träger, auch Substrat oder Basismaterial genannt, aufgebracht. Sie bedeckt zumindest teilweise eine Oberfläche des Trägers, kurz Trägeroberfläche. Die Schicht weist somit eine Ausdehnung entlang einer erstens Achse und einer zweiten Achse auf, wobei erste Achse und zweite Achse parallel zur Trägeroberfläche angeordnet sind. Die Schicht weist weiter eine Ausdehnung entlang einer dritten Achse senkrecht zur Trägeroberfläche, auf, die Schichtdicke genannt wird. Die Schicht ist derart ausgeführt, dass sie auch gegebenenfalls eine Topografie der Trägeroberfläche gleichförmig bedeckt. Die Schichtdicke wird mit einem Röntgenfluoreszenz-Verfahren nach ISO 3497:2000 der International Organization for Standardization bestimmt.

Die zweite Schicht ist zu mindestens 90 Gew.% (90 Gewichtsprozent) aus einem Edelmetall ausgeführt. Dies hat den Vorteil, dass die Schicht korrosionsbeständig ist und somit eine hohe chemische Beständigkeit aufweist. Edelmetalle sind Elemente, die ein stark positives Standardpotential, auch Normalpotential gegenüber einer Wasserstoffelektrode genannt, aufweisen. So weist beispielsweise Gold ein Standardpotential von 1.5 V (Volt), Silber ein Standardpotential von 0.8 V auf. Zudem weist die zweite Schicht durch den hohen Anteil an Edelmetall eine hohe Leitfähigkeit auf und ist damit als Elektrode zur Ladungsleitung und zur Kontaktierung durch einen Leiter geeignet.

Die erste Schicht ist aus Übergangsmetallen und/oder Metallen und/oder Halbmetallen ausgeführt. Die Formulierung und/oder ist als nicht ausschließende Disjunktion zu verstehen. Die erste Schicht ist ultraschalldämpfend. Dies hat den Vorteil, dass die mechanische Beanspruchung des Trägers durch Vibrationen, wie z.B. Ultraschall, reduziert werden. So wird vorteilhaft die mechanische Beanspruchung des Trägers durch die mechanischen Schwingungen, wie sie beispielsweise beim Drahtbonden auftreten, reduziert. Insbesondere bei oxidkeramischen Trägern ist die Haftfestigkeit einer stoffschlüssigen Verbindung von Leiter und zweiter Schicht nach dem Drahtbonden erhöht.

Beim Drahtbonden wird ein erstes Ende eines Leiters, auch Bonddraht genannt, mit einem Bondwerkzeug auf die zweite Schicht gedrückt. Das Bondwerkzeug überträgt Ultraschallschwingungen auf den Leiter. Dies führt zu Diffusionsvorgängen zwischen Leiter und zweiter Schicht, wodurch eine stoffschlüssige Verbindung entsteht. Der Ultraschall ist jedoch nicht auf die erste Schicht lokalisiert, sondern breitet sich durch die erste Schicht und die zweite Schicht zum Träger aus. Durch die ultraschalldämpfende zweite Schicht wird die mechanische Beanspruchung des Trägers durch die mechanischen Schwingungen des Ultraschalls reduziert.

Weitere Vorteile und Aspekte der Erfindung sind in den Ausführungsbeispielen offenbart.

### Kurze Beschreibung der Zeichnungen

Im Folgenden wird die Erfindung beispielhaft unter Beizug der Figuren näher erklärt. Es zeigen
- Fig. 1: zeigt eine schematische Schnittansicht einer Ausführungsform eines Systems,
- Fig. 2: zeigt eine schematische Schnittansicht einer Ausführungsform eines kontaktierten Systems,
- Fig. 3: zeigt eine schematische Schnittansicht einer weiteren Ausführungsform eines kontaktierten Systems.
- Fig. 4: zeigt eine schematische Teilansicht einer weiteren Ausführungsform eines kontaktierten Systems;
- Fig. 5: zeigt eine schematische Teilansicht einer weiteren Ausführungsform eines kontaktierten Systems;
- Fig. 6: zeigt eine schematische Teilansicht einer weiteren Ausführungsform eines kontaktierten Systems.

Gleiche Bezugszeichen bezeichnen in den Figuren gleiche Gegenstände oder Merkmale.

### Wege zur Ausführung der Erfindung

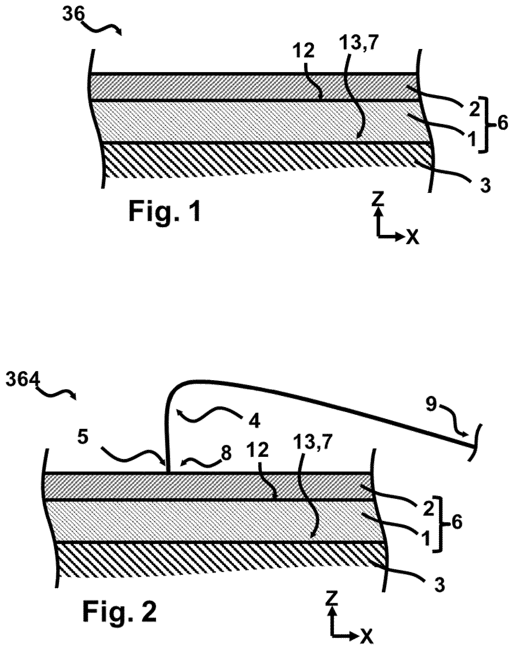

Fig. 1 zeigt eine schematische Schnittansicht einer Ausführungsform eines Systems 36. Das System 36 in Fig. 1 weist einen Träger 3 und eine Metallisierung 6 auf. Die Metallisierung 6 weist eine erste Schicht 1 und eine zweite Schicht 2 auf. Der Träger 3 weist eine Trägeroberfläche 7 auf, welche sich in der beispielhaften Fig. 1 entlang einer ersten Achse X und in die Bildebene hinein erstreckt. Das System 36 ist demnach schematisch in einem Schnitt senkrecht zur Trägeroberfläche 7 dargestellt. Die erste Schicht 1 ist zwischen Trägeroberfläche 7 und der zweiten Schicht 2 angeordnet.

Die in Fig. 1 bis Fig. 6 dargestellten Dimensionen sind weder massstabsgetreu dargestellt, noch sind die Dimensionen der einzelnen Elemente zueinander aus dem Grössenverhältnis zueinander zu entnehmen. Es handelt sich um eine rein schematische Darstellung.

Erfindungsgemäss ist in allen in den Figuren dargestellten, beispielhaften, und allen weiteren, nicht dargestellten Ausführungsformen die zweite Schicht 2 zu mindestens 90 Gew.% aus einem Edelmetall ausgeführt. Dies hat den Vorteil, dass die zweite Schicht 2 korrosionsbeständig ist und somit eine hohe chemische Beständigkeit aufweist. Zudem weist die zweite Schicht 2 durch den hohen Anteil an Edelmetall eine hohe Leitfähigkeit auf und ist damit als Elektrode zur Ladungsleitung und zur Kontaktierung durch einen Leiter 4 geeignet, wie beispielhaft in Fig. 2 bis Fig. 6 dargestellt..

Die erste Schicht 1 ist erfindungsgemäss in allen Ausführungsformen aus Übergangsmetallen und/oder Metallen und/oder Halbmetallen ausgeführt. Ebenfalls erfindungsgemäss ist die erste Schicht 1 ultraschalldämpfend. Unter ultraschalldämpfend wird eine Verminderung der Intensität von Schallwellen, welche die ultraschalldämpfende Schicht queren, verstanden. Dies hat den Vorteil, dass die mechanische Beanspruchung des Trägers 3 durch Vibrationen, wie z.B. Ultraschall, reduziert werden. So wird vorteilhaft die mechanische Beanspruchung des Trägers 3 durch die mechanischen Schwingungen, wie sie beispielsweise beim Drahtbonden auftreten, reduziert. Insbesondere bei oxidkeramischen Trägern 3 ist die Haftfestigkeit einer stoffschlüssigen Verbindung von Leiter 9 und zweiter Schicht 2 nach dem Drahtbonden erhöht.

Bevorzugt weist die erste Schicht 1 einen mechanischen Verlustfaktor (loss coefficient) von mindestens 10⁻⁴ auf. Dies hat den Vorteil, dass das System 36 mittels Drahtbonden kontaktierbar ist, während die mechanische Beanspruchung des Trägers derart minimiert ist, dass die Gefahr einer Beschädigung des Trägers durch mechanische Schwingungen reduziert ist. Der unter Verlustfaktor wird dabei ein Faktor nach «On the Engineering Properties of Materials», M. F. Ashby, Acta metall. Vol. 37, No. 5, pp. 1273-1293, (1989) verstanden, welcher darin als loss coefficient oder damping coefficient η (kleiner griechischer Buchstabe Eta) bezeichnet ist. In der Publikation von Ashby ist der Verlustfaktor gleich dem Tangens des Verlustwinkels und gleich dem Verhältnis des Verlustmoduls zum Speichermodul und daher einheitenlos. In erster Näherung ist der Verlustfaktor antiproportional zum Elastizitätsmodul (engl. Young's Modulus) eines Werkstoffes wie einer Legierung oder eines Metalls.

Der Elastizitätsmodul eines Werkstoffes bezieht sich jeweils auf einen makroskopischen Körper, auch in der Fachliteratur als Massivprobe bezeichnet, des Werkstoffes und wird nach DIN EN ISO 6892-1 und/oder DIN EN ISO 6892-2 bestimmt.

Der Verlustfaktor wird bestimmt wie in «A Comprehensive Report on Ultrasonic Attenuation of Engineering Materials, Including Metals, Ceramics, Polymers, Fiber-Reinforced Composites, Wood, and Rocks», Kanji Ono, Appl. Sci., 10, 2230 (2020) beschrieben.

Besonders bevorzugt weist die erste Schicht 1 einen Verlustfaktor von mindestens 10⁻⁴ und zudem eine Schichtdicke zwischen etwa 500 nm (Nanometer) bis etwa 4 um (Micrometer) auf. Es hat sich gezeigt, dass durch Schichten mit einer geringeren Schichtdicke keine adäquate mechanische Dämpfung einer mechanischen Schwingung, welche in die zweite Schicht 2 eingetragen wird durch die erste Schicht 1 erzielbar ist, damit eine Beschädigung des Trägers vermieden wird. Andererseits führt eine zu hohe Schichtdicke der ersten Schicht über 4 um zu einer Verringerung der Haftvermittlung aufgrund der Eigenspannungen in der Schicht. Diese kann zu einem Abplatzen der Schicht führen.

In einer Ausführungsform weist die erste Schicht 1 zudem einen Verlustfaktor von mindestens 10⁻⁴ für mechanische Schwingungen mit einer Frequenz zwischen 20 kHz und 200 kHz, bevorzugt zwischen 40 kHz und 160 kHz auf. Dies ist vorteilhaft, da Drahtbonden üblicherweise im Frequenzbereich zwischen 20 kHz und 200 kHz ausgeführt wird, wobei die meisten kommerziellen Geräte zum Drahtbonden derzeit bei einer Frequenz zwischen 40 kHz und 160 KHz arbeiten.

In einer Ausführungsform weist die erste Schicht 1 zudem ein Elastizitätsmodul zwischen 60 GPa und 130 GPa; bevorzugt zwischen 80 GPa und 100 GPa auf. Dies ist vorteilhaft, da die durch den Ultraschall erzeugten Spannungen die Schicht weniger ausdehnt. Dies ist nach dem Hooke'schen Gesetz bekannt, da eine Dehnung gleich einer Spannung geteilt durch das Elastizitätsmodul ist. Das Risiko einer Beschädigung der ersten Schicht 1 selbst durch mechanische Beanspruchung, beispielsweise bei auf die erste Schicht wirkenden Ultraschallschwingungen, ist so reduziert.

Bevorzugt besteht die erste Schicht 1 aus einem Metall oder einer Legierung, die im Temperaturbereich bis 350°C eine negative Standardbildungsenthalpie für das Oxid des betreffenden Metalls oder der Legierung aufweist. Dies hat den Vorteil, dass die erste Schicht 1 eine erhöhte Haftfähigkeit am Träger 3 aufweist im Vergleich zu einer Schicht aus einer Legierung mit einer neutralen oder positiven Standardbildungsenthalpie für das Oxid.

Eine negative Standardbildungsenthalpie bedeutete eine negative Gibbs-Oxidationsenergie im Ellingham-Diagramm.

Die Standardbildungsenthalpie wird an einem makroskopischen Festkörper des Materials der Schicht, auch Massivprobe genannt, bestimmt. Die Bestimmung der Standardbildungsenthalpie erfolgt nach DIN 51007-1 mittels Kalorimetrie und dem Satz von Hess, auch als Hess'scher Wärmesatz (engl.: Hess' law of constant heat summation, also known as Hess' law) .

Bevorzugt ist die erste Schicht 1 aus Bronze ausgeführt. Bronze, auch Bronzelegierung genannt, ist eine Kupferlegierung.

Die Metallisierung 6 in ihren verschiedenen Ausführungsvarianten ist besonders für Systeme 36 geeignet, wenn der Träger 3 eine Oxidkeramik ist. Der Träger 3 weist dann ein Elastizitätsmodul zwischen 60 GPa und 120 GPa und einen thermischen Längenausdehnungskoeffizienten zwischen α=5·10⁻⁶ K⁻¹ und α=20·10⁻⁶ K⁻¹ auf.

Der thermische Längenausdehungskoeffizient bezieht sich auf den thermischen Längenausdehnungskoeffizienten des Materials der Schicht oder der Oxidkeramik als makroskopischer Festkörper, auch Massivprobe genannt. Der thermische Längenausdehungskoeffizient wird nach DIN 51045-1 mittels Dilatometer bestimmt.

Der thermische Längenausdehungskoeffizient, kurz Längenausdehnungskoeffizient, wird auch synonym als Wärmeausdehnungskoeffizient bezeichnet.

Spezielle Oxidkeramiken, die besonders anfällig auf Beschädigung durch mechanische Beanspruchung sind, weisen ein Elastizitätsmodul zwischen 90 GPa und 110 GPa sowie eine thermischen Längenausdehnungskoeffizienten zwischen α=12·10⁻⁶ K⁻¹ und α=18·10⁻⁶ K⁻¹ auf.

Bevorzugt ist die erste Schicht 1 als Haftvermittler für die Trägeroberfläche 7 ausgeführt und mit der Trägeroberfläche 7 stoffschlüssig verbunden. Die erste Schicht 1 ist somit sowohl ultraschalldämpfend ausgeführt als auch Haftvermittler zwischen zweiter Schicht 2 und Träger 3. Dies ist vorteilhaft, da so eine gute Kontaktierbarkeit des Systems mit einem Leiter 9 und die Beständigkeit dieser Kontaktierung des Leiters 9 mit der zweiten Schicht 2 gegeben ist. Es wird sowohl eine Beschädigung des Trägers 3 vermieden als auch eine gute Haftung der zweiten Schicht 2 am Träger 3 vermittelt.

Bevorzugt weist die erste Schicht 1 einen thermischen Ausdehnungskoeffizienten zwischen α=5·10⁻⁶·K⁻¹ und α=18·10⁻⁶·K⁻¹ auf. Dies ist vorteilhaft, da so thermisch induzierte mechanische Spannungen zwischen erster Schicht 1 und Träger 3 vermieden werden. Thermisch induzierte mechanische Spannungen treten bei einer Temperaturänderung zwischen zwei Werkstoffen auf, wenn sich diese in ihren thermischen Ausdehnungskoeffizienten stark unterscheiden.

Bevorzugt weist die zweite Schicht 2 eine Schichtdicke zwischen 20 nm und 300 nm auf. Die zweite Schicht 2 ist als zur Kontaktierung mit einem Leiter 9 mittels Drahtbonden geeignet und weist schon bei geringen Schichtdicken von 20 nm eine gute elektrische Leitfähigkeit auf. Schichtdicken oberhalb 300 nm sind zum einen aus Kostengründen zu vermeiden. Des Weiteren können mit zunehmender Schichtdicke der zweiten Schicht mechanische Spannungen zwischen erster Schicht 1 und zweiter Schicht 2 im Fall unterschiedlicher thermischer Ausdehnungskoeffizienten ansteigen. Bei Schichtdicken oberhalb 300 nm weist die zweite Schicht 2 eine unvorteilhafte Eigenspannung auf.

Besonders vorteilhaft weist die zweite Schicht 2 eine hohe chemische Beständigkeit auf. So ist vorteilhaft die erste Schicht 1 gegen Umwelteinflüsse, beispielsweise Oxydation durch Sauerstoff geschützt. Hier eignen sich insbesondere Gold oder Platin oder Goldlegierungen oder Platinlegierungen als Werkstoff der zweiten Schicht 2.

Besonders vorteilhaft weist die zweite Schicht 2 eine hohe mechanische Beständigkeit auf. So ist vorteilhaft die erste Schicht 1 gegen Umwelteinflüsse, beispielsweise kratzerverursachende mechanische Belastung geschützt. Dafür weist die zweite Schicht 2 ein Elastizitätsmodul grösser 150 GPa auf. Geeignet ist hier insbesondere Platin oder Platinlegierungen als Werkstoff der zweiten Schicht 2. Platin und Platinlegierungen weisen eine hohe Kratzfestigkeit auf. Ein hohe Kratzfestigkeit ist bei einer Mohshärte > 3 gegeben. Bevorzugt weist die zweite Schicht 2 eine Mohshärte > 3 auf. Gold weist eine Mohshärte von etwa 2.5 auf und gilt daher nicht als kratzfest. Platin weist eine Mohshärte von 3.4 auf und ist daher, wie auch Platinlegierungen mit einer Mohshärte > 3, kratzfest.

Besonders bevorzugt ist die erste Schicht 1 eine Bronzelegierung, welche Kupfer, Zinn und Nickel aufweist; wobei bevorzugt die erste Schicht (1) 84.5 Gew.% bis 87.5 Gew.% Kupfer, 11 Gew.% bis 13 Gew.% Zinn, 1.5 Gew.% bis 2.5 Gew.% Nickel aufweist. Insbesondere bevorzugt weist die erste Schicht 1 maximal 16 Gew.% Elemente ausser Kupfer, Zinn und Nickel auf. Es hat sich gezeigt, dass eine solche Bronzelegierung ein besonders vorteilhaftes E-Modul (Elastizitätsmodul) von etwa 90 GPa und einen besonders vorteilhaften Wärmeausdehnungskoeffizienten von 17.5·10⁻⁶ K⁻¹ aufweist, womit die zweite Schicht 2 sich besonders als ultraschalldämpfender Haftvermittler für die speziellen Oxidkeramiken mit einem Elastizitätsmodul zwischen 90 GPa und 110 GPa sowie einem thermischen Längenausdehnungskoeffizienten zwischen α=12·10⁻⁶ K⁻¹ und α=18·10⁻⁶ K⁻¹ eignet. Für eine bevorzugt gute Kontaktierbarkeit des Systems mittels Drahtbonden weicht das Elastizitätsmodul der ersten Schicht 1 um nicht mehr als 20%, bevorzugt 10%, vom Elastizitätsmodul des Trägers 3 ab. Es hat sich gezeigt, dass für eine besonders gute Beständigkeit des Systems 36 gegenüber Beschädigung des Trägers 3 der Wärmeausdehnungskoeffizient der ersten Schicht 1 um nicht mehr als 20%, bevorzugt 10%, vom Wärmeausdehnungskoeffizienten des Trägers 3 abweicht.

Die Metallisierung 6 ist besonders für einen Träger 3 aus einem piezoelektrischen Material, bevorzugt einem piezoelektrischen Kristall geeignet. Piezoelektrische Materialien werden oft im Zusammenhang mit mechanischer Belastung genutzt, beispielsweise als Aktuator, bei dem an eine Trägeroberfläche eine elektrische Spannung angelegt wird, oder als piezoelektrisches Messelement, bei dem eine mechanische Kraft auf eine Trägeroberfläche 7 ausgeübt wird. Die hier beschriebene Metallisierung 6 ist durch ihre mechanische Beständigkeit besonders robust gegenüber äusseren mechanischen Einflüssen.

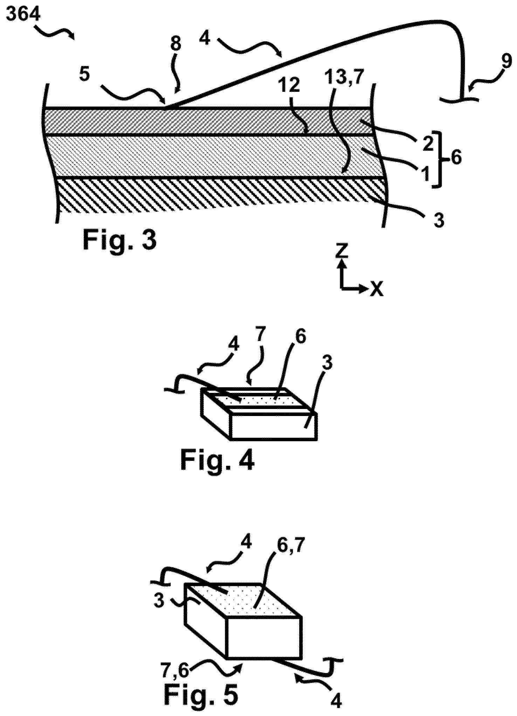

Ein Träger 3 mit Metallisierung 6 wird oftmals mit einem Leiter kontaktiert, wie in den Fig. 2 und Fig. 3 beispielhaft dargestellt. Ein derart kontaktierter Träger 3 wird als kontaktiertes System 364 bezeichnet. Ein kontaktiertes System 364 weist einen Träger 3, mindestens eine Metallisierung 6 und mindestens einen Leiter 4 auf. Der Leiter 4 weist ein erstes Leiterende 8 und ein zweites Leiterende 9 auf. Das erste Leiterende 8 ist mit der zweiten Schicht 2 stoffschlüssig verbunden. Die zweite Schicht 2 weist eine gute Bondbarkeit mit dem Leiter 4 auf. Ein Leiter 4 ist beispielsweise ein Bonddraht, bevorzugt ein Bonddraht aus Gold oder ein Bonddraht aus Aluminium.

Der Leiter 4 ist in einem kontaktierten System 364 mit der zweiten Schicht 2 bevorzugt mit einem Ball-Bond 5, wie in Fig. 2 angedeutet, oder einem Wedge-Bond 5, wie in Fig. 3 angedeutet, stoffschlüssig verbunden.

Die Fig. 4 bis 6 zeigen beispielhaft einige Ausführungsbeispiele eines kontaktierten Systems 364. Die Ausführungsformen sind jedoch nicht auf die gezeigten Ausführungsbeispiele beschränkt. So sind insbesondere auch andere teilweise Abdeckungen einer Trägeroberfläche 7 oder andere geometrische Ausgestaltungen eines Trägers denkbar. Ebenfalls ist beispielshaft nur eine oder zwei Kontaktierungen durch einen Leiter 4 dargestellt. Es sind jedoch ausdrücklich hingewiesen, dass auch mehrere Kontaktierungen durch mehrere Leiter 4 möglich sind.

Fig. 4 zeigt einen quaderförmigen Träger 3. Eine der Oberflächen ist als Trägeroberfläche 7 teilweise mit einer streifenförmigen Metallisierung 6 bedeckt, welche als punktierte Fläche dargestellt ist. Die Metallisierung 6 ist mit einem Leiter 4 an einem ersten Leiterende 8 (in Fig. 4 bis 6 der Übersichtlichkeit halber nicht dargestellt, in Fig. 2 und 3 dargestellt) mit einer Verbindung 5 stoffschlüssig verbunden. Der Leiter ist hier, wie auch in den Fig. 2 bis 6, mit beliebiger Länge dargestellt, was durch die geschweifte Bruchkante dargestellt ist. Das zweite Leiterende ist nicht dargestellt. Der Fachmann kann die Metallisierung analog zum Ausführungsbeispiel der Fig. 4 auch als Leiterbahnen auf einem Träger 3 gestalten.

In Fig. 5 ist ein Ausführungsbeispiel, bei der die obere Fläche und die untere Fläche eines quaderförmigen Trägers 3 in ihrer Gesamtheit mit jeweils einer Metallisierung 6 bedeckt sind. Jede Metallisierung 6 ist mit einem Leiter 4 an einem ersten Leiterende 8 mit einer Verbindung 5 stoffschlüssig verbunden. Dieses Ausführungsbeispiel ist beispielsweise als piezoelektrisches Messelement mit dem piezoelektrischen Transversaleffekt einsetzbar, wobei mittels der Metallisierung 6 piezoelektrische Ladungen bei einer seitlichen Kraftbeaufschlagung des quaderförmigen Trägers 3 abgeleitet werden können. Die jeweiligen zweiten Enden 9 des Leiters (nicht dargestellt) sind im Fall eines als piezoelektrischen Messelement ausgeführten Trägers üblicherweise mit einem Ladungsverstärker oder einem Impedanzwandler (beide nicht dargestellt) elektrisch leitend verbunden. Der Fachmann kann auch einen Randbereich der oberen und unteren Fläche ohne Metallisierung ausführen, um eine seitliche Kontaktierung zu vermeiden (nicht dargestellt)

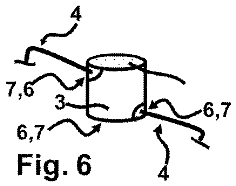

Fig. 6 ist ein Ausführungsbeispiel, bei der die obere Fläche und die untere Fläche eines scheibenförmigen Trägers 3 in ihrer Gesamtheit mit jeweils einer Metallisierung 6 bedeckt sind. Die Mantelfläche weist zwei Teilbereiche mit einer Metallisierung 6 auf, von denen jeweils eines mit einer Metallisierung der oberen, respektive unteren Fläche elektrisch leitend verbunden sind und demnach in diesem Ausführungsbeispiel jeweils eine Metallisierung 6, also insgesamt 2 elektrisch voneinander getrennte Metallisierungen 6 bilden. Dieses Ausführungsbeispiel zeigt, dass eine Metallisierung 6 auch über Kanten eines Trägers 3 hinweg ausgeführt sein kann, also an die Topografie des Trägers 3 anpassbar ist. Jede Metallisierung 6 ist mit dem Teilbereich auf der Mantelfläche mit einem Leiter 4 an einem ersten Leiterende 8 mit einer Verbindung 5 stoffschlüssig verbunden. Dieses Ausführungsbeispiel ist beispielsweise als piezoelektrisches Messelement mit dem piezoelektrischen Longitudinaleffekt einsetzbar, wobei mittels der Metallisierung 6 piezoelektrische Ladungen bei einer Kraftbeaufschlagung entlang der vertikalen Achse des zylinderförmigen Trägers 3 abgeleitet werden können. Die jeweiligen zweiten Enden 9 des Leiters (nicht dargestellt) sind im Fall eines als piezoelektrischen Messelement ausgeführten Trägers üblicherweise mit einem Ladungsverstärker oder einem Impedanzwandler (beide nicht dargestellt) elektrisch leidend verbunden.

Ein System 34 wird beispielsweise hergestellt, indem in einem ersten Schritt ein Träger 3 bereitgestellt wird. Der Träger 3 weist eine Trägeroberfläche 7 auf, auf der in einem zweiten Schritt eine erste Schicht 1 aufgebracht wird. Die ersten Schicht 1 wird üblicherweise durch Sputtern, auch Kaltkathodenzerstäubung genannt, oder durch Aufdampfen auf die Trägeroberfläche 7 aufgebracht. Eine Formgebung der ersten Schicht 1 wird mittels Maskierung und/oder Laserstrukturierung der Trägeroberfläche 7 realisiert. In einem dritten Schritt wird eine zweite Schicht 2 auf die erste Schicht 1 aufgebracht. Die zweite Schicht 2 wird üblicherweise ebenfalls durch Sputtern oder durch Aufdampfen auf die Trägeroberfläche 7 aufgebracht. Eine Formgebung der zweiten Schicht 2 wird mittels Maskierung und/oder Laserstrukturierung der Trägeroberfläche 7 realisiert. Die zweite Schicht kann auch mittels galvanischem Verfahren aufgebracht werden. Möglich wäre auch Laserstrukturierung nachdem erste Schicht 1 und zweite Schicht 2 aufgebracht wurden.

Alle Angaben zu physikalischen Grössen und Eigenschaften beziehen sich, soweit nicht anders angegeben, auf eine Temperatur von 20°C und normalem Umgebungsdruck (Normaldruck) von 101,3kPa (Kilopascal).

Es sind explizit in dieser Schrift auch Ausführungsformen einbezogen, welche eine Kombination der Merkmale hierin beschriebener Ausführungsformen aufweisen.

### Bezugszeichenliste

- 1: Erste Schicht
- 2: Zweite Schicht
- 3: Träger
- 4: Leiter, Bonddraht
- 5: Verbindung, Bond, Stoffschlüssige Verbindung, Ball-Bond, Wedge-Bond
- 6: Metallisierung
- 7: Trägeroberfläche
- 8: Erstes Leiterende
- 9: Zweites Leiterende
- 12: Kontaktebene
- 13: Kontaktebene
- 36: System
- 364: Kontaktiertes System
- X: Erste Achse
- Y: Zweite Achse
- Z: Dritte Achse

## Patentansprüche

1. System (36) aufweisend einen Träger (3) und mindestens eine Metallisierung (6); wobei die Metallisierung (6) zumindest eine erste Schicht (1) und eine zweite Schicht (2) aufweist; wobei der Träger eine Oxidkeramik ist; wobei der Träger (3) eine Trägeroberfläche (7) aufweist; wobei die erste Schicht (1) zwischen Trägeroberfläche und der zweiten Schicht (2) angeordnet ist; wobei die zweite Schicht (2) zu mindestens 90 Gew.% aus einem Edelmetall ausgeführt ist; wobei die erste Schicht (1) aus Übergangsmetallen und/oder Metallen und/oder Halbmetallen ausgeführt ist; **dadurch gekennzeichnet, dass** die erste Schicht (1) ultraschalldämpfend ist; und dass die erste Schicht (1) einen Verlustfaktor von mindestens 10⁻⁴ und eine Schichtdicke von 500 nm bis 4 um aufweist.

2. System (36) nach dem vorgehenden Anspruch, **dadurch gekennzeichnet, dass** die erste Schicht (1) einen Verlustfaktor von mindestens 10⁻⁴ für mechanische Schwingungen mit einer Frequenz zwischen 20 kHz und 200 kHz, bevorzugt zwischen 40 kHz und 160 kHz aufweist.

3. System (36) nach einem der vorgehenden Ansprüche, **dadurch gekennzeichnet, dass** die erste Schicht (1) ein Elastizitätsmodul zwischen 60 GPa und 130 GPa; bevorzugt zwischen 80 GPa und 100 GPa aufweist.

4. System (36) nach einem der vorgehenden Ansprüche, **dadurch gekennzeichnet, dass** die erste Schicht (1) aus einem Metall oder einer Legierung besteht, die im Temperaturbereich bis 350°C eine negative Standardbildungsenthalpie für das Oxid des betreffenden Metalls oder der Legierung aufweist; und dass die erste Schicht (1) aus Bronze oder einer Kupferlegierung ausgeführt ist

5. System (36) nach einem der vorgehenden Ansprüche, **dadurch gekennzeichnet, dass** der Träger (3) einen Elastizitätsmodul zwischen 60 GPa und 120 GPa und einem thermischen Längenausdehnungskoeffizienten zwischen α=5·10⁻⁶ K⁻¹ und α=20·10⁻⁶ K⁻¹, bevorzugt zwischen α=6·10⁻⁶ K⁻¹ und α=18·10⁻⁶ K⁻¹, besonders bevorzugt zwischen α=12·10⁻⁶ K⁻¹ und α=18·10⁻⁶ K⁻¹ aufweist; oder dass der Träger (3) eine Oxidkeramik ist mit einem Elastizitätsmodul zwischen 90 GPa und 110 GPa und einem thermischen Längenausdehnungskoeffizienten zwischen α=12·10⁻⁶ K⁻¹ und α=18·10⁻⁶ K⁻¹ aufweist.

6. System (36) nach einem der vorgehenden Ansprüche, **dadurch gekennzeichnet, dass** die erste Schicht (1) als Haftvermittler für die Trägeroberfläche (7) ausgeführt ist und mit der Trägeroberfläche (7) stoffschlüssig verbunden ist; und dass die erste Schicht (1) einen thermischen Ausdehnungskoeffizienten zwischen α=5·10⁻⁶ K⁻¹ und α=18·10⁻⁶ K⁻¹ aufweist.

7. System (36) nach einem der vorgehenden Ansprüche, **dadurch gekennzeichnet, dass** die zweite Schicht (2) eine Schichtdicke zwischen 20 nm und 300 nm aufweist.

8. System (36) nach einem der vorgehenden Ansprüche, **dadurch gekennzeichnet, dass** die zweite Schicht (2) eine hohe mechanische Beständigkeit aufweist und beispielsweise aus Platin oder einer Platinlegierung mit mindestens 90 Gew.% (Gewichtsprozent) Platinanteil ausgeführt ist.

9. System (36) nach einem der vorgehenden Ansprüche, **dadurch gekennzeichnet, dass** die erste Schicht (1) eine Bronzelegierung ist, welche Kupfer, Zinn und Nickel aufweist; wobei bevorzugt die erste Schicht (1) 84.5 Gew.% bis 87.5 Gew.% Kupfer, 11 Gew.% bis 13 Gew.% Zinn, 1.5 Gew.% bis 2.5 Gew.% Nickel aufweist; und wobei die erste Schicht (1) maximal 16 Gew.% Elemente ausser Kupfer, Zinn und Nickel aufweist.

10. System (36) nach dem vorgehenden Anspruch; wobei das Elastizitätsmodul der ersten Schicht (1) um nicht mehr als 20%, bevorzugt 10%, vom Elastizitätsmodul des Trägers (3) abweicht.

11. System (36) nach dem vorgehenden Anspruch; wobei der Wärmeausdehnungskoeffizient der ersten Schicht (1) um nicht mehr als 20%, bevorzugt 10%, vom Wärmeausdehnungskoeffizienten des Trägers (3) abweicht.

12. System (36) nach dem vorgehenden Anspruch; wobei der Träger (3) ein piezoelektrisches Material, bevorzugt ein piezoelektrischer Kristall ist.

13. System (36) nach einem der vorgehenden Ansprüche, **dadurch gekennzeichnet, dass** die zweite Schicht (2) einen Elastizitätsmodul grösser 150 GPa aufweist.

14. System (36) nach einem der vorgehenden Ansprüche, **dadurch gekennzeichnet, dass** die zweite Schicht (2) eine hohe Kratzfestigkeit aufweist, wobei die zweite Schicht (2) eine Mohshärte > 3 aufweist.

15. Kontaktiertes System (364); wobei das kontaktierte System (364) mindestens einen Leiter (4) und ein System aus Träger (3) und mindestens einer Metallisierung (6) nach einem der Ansprüche 1 bis 12 aufweist; welcher Leiter (4) ein erstes Leiterende (8) und ein zweites Leiterende (9) aufweist; wobei das erste Leiterende (8) mit der zweiten Schicht (2) stoffschlüssig verbunden ist; wobei die zweite Schicht (2) eine gute Bondbarkeit mit dem Leiter 4 aufweist, wobei der Leiter (4) beispielsweise ein Bonddraht aus Gold oder ein Bonddraht aus Aluminium ist.
